# EUROPEAN PATENT APPLICATION

(11) **EP 4 455 931 A1**
(43) Date of publication of application: **30.10.2024**
(21) Application number: 23170465.1
(22) Date of filing: 27.04.2023
(51) Int. Cl.: G06F 40/40, G06F 40/30, G06F 11/34, G06F 40/284, G06F 40/211

(54) **SYSTEM AND METHOD FOR GENERATING ONE OR MORE SIMULATION SCENARIOS FOR A SIMULATION MODEL IN A SIMULATION ENVIRONMENT PERTAINING TO ONE OR MORE ASSETS IN AN ENVIRONMENT**

(71) Applicant: Siemens Aktiengesellschaft, 80333 München (DE)
(72) Inventor: JITTA, Divya Sai, 560100 Bangalore, Karnataka (IN); JOSEPH, Rani, 560076 Bangalore (IN); KUMAR, Naveen, 560100 Bangalore, Karnataka (IN)
(74) Representative: Patentanwaltskanzlei WILHELM & BECK

(57) **Abstract**

Disclosed is a system (100), apparatus (105) and method (200) for generating one or more simulation scenarios for a simulation model in a simulation environment pertaining to one or more assets in an environment. The method (200) comprises receiving, by a processing unit (120), a technical document from a source; extracting at least one word phrase from at least one sentence pertaining to a particular simulation scenario in the technical document; assigning the at least one word phrase to a header in a preconfigured template using a classifier model, wherein the preconfigured template comprises one or more categories of headers; and wherein the preconfigured template is capable of semantically describing the simulation scenario when populated with extracted word phrases; and generating one or more simulation scenarios using the preconfigured template having headers assigned to the least one word phrase.

## Description

The present invention relates to a field of simulation, and more particularly relates to a system, apparatus and method for generating one or more simulation scenarios for a simulation model in a simulation environment pertaining to one or more assets in an environment.

Autonomous systems such as automatic machines, robots, autonomous vehicles, automatic electro-mechanical systems etc. require a huge amount of data for training to perform accurately in a real-world environment. For this purpose, the autonomous systems are to be trained in a simulation environment with maximum possible simulation instances. However, creation of simulation instances that can effectively train the autonomous systems is a huge challenge and requires a trainer/operator to create different simulation scenarios that can be used as input dataset for training the autonomous systems. Furthermore, creation of simulation instances manually is a time consuming activity. In industrial environments where autonomous systems are to be trained for dynamic changes in the environment, creation of simulation instances for every possible scenario is difficult to curate and hence renders the outcome of the autonomous systems error-prone.

For this purpose, one approach is to use available information (in the form of technical documents, diagrams, product manuals etc.) pertaining to the autonomous systems. These technical documents are however written in spoken language and hence the technical documents need to be processed to extract relevant information from therein. However, in a highly regulated environment using machine learning approaches like Natural Language Processing (NLP) can be challenging due to the risk impacts and meeting the compliance parameters. One of the crucial aspects here is to ensure an accurate extraction of the intent from a set of statements without altering the semantics. One such domain is that of Autonomous Vehicles (AV) where there is a greater interest to simulate scenarios to train the AVs and validate against a knowledge base created by the OEM domain experts. This assures the functional performance and safety characteristics of AV's instead of physically driving the vehicle for hundreds of millions of miles to demonstrate their reliability in terms of fatality and injuries.

The domain expert authors a set of requirements that need to be met for reliable driving by the AVs. These requirements form a part of the knowledge base for OEMs to train and validate the AVs through simulation. These requirements are written in natural language with a mix of domain specific references with unstructured conditional statements. They can run into multiple set of individual statements which are co-related and semantically linked. Hence manually interpreting these natural language statements and translating them to create inputs for simulation is a tedious and time-consuming process.

In light of the above, there exists a need for a mechanism for a system, apparatus and method for automatically generating one or more simulation scenarios for a simulation model in a simulation environment pertaining to one or more assets using natural language processing.

Therefore, it is an object of the present invention to provide a system, apparatus and method for generating one or more simulation scenarios for a simulation model in a simulation environment pertaining to one or more assets.

The object of the present invention is achieved by a method for generating one or more simulation scenarios for a simulation model in a simulation environment pertaining to one or more assets.

The method comprises receiving, by a processing unit, a technical document from a source, wherein the technical document comprises text-based specifications pertaining to behavior of the one or more assets in the simulation environment. The source may be one or more of a client device, a database or a server. Further, the data may be one of structured data and unstructured data. The technical document is in one of a searchable format and a non-searchable format. Specifically, searchable formats allow a user to search through the document for specific text with the help of keywords. Non-limiting examples of searchable formats include knowledge models, searchable PDFs, emails, Word, Excel and HTML. On the contrary, non-searchable formats non-searchable Portable Document Formats (PDFs), Portable Network Graphics (PNG) format, Joint Photographic Experts Group (JPEG) format, JPEG, JPG and other image formats. In one example, the technical document may be a scanned image of a hard copy. Non-limiting examples of technical documents include service reports, product catalogs, product manuals and design specifications. In an embodiment, receiving the request for generating one or more simulation scenarios for a simulation model in a simulation environment pertaining to one or more assets comprise receiving the technical document as an input from the source.

The method comprises extracting, by the processing unit, at least one word phrase from at least one sentence pertaining to a particular simulation scenario in the technical document. In one embodiment, extracting at least one word phrase from at least one sentence comprises automatically parsing the technical document using one or more machine learning models.

Each of the one or more machine learning model is trained to perform a certain function. In particular, by training based on training data, the machine learning model is able to adapt to new circumstances and to detect and extrapolate patterns. In general, parameters of the machine learning model may be adapted by means of training. In particular, supervised training, semi-supervised training, unsupervised training, reinforcement learning and/or active learning may be used. Furthermore, feature learning may be used. In particular, the parameters of the machine learning model may be adapted iteratively by several steps of training. In particular, a machine learning model may comprise a neural network, a support vector machine, a decision tree and/or a Bayesian network, and/or the machine learning model may be based on k-means clustering, Qlearning, genetic algorithms and/or association rules.

In particular, a neural network may be a deep neural network, a convolutional neural network or a convolutional deep neural network or variations thereof. Furthermore, a neural network may be an adversarial network, a deep adversarial network and/or a generative adversarial network. During parsing the technical document is provided as input to the one or more machine learning models. Specifically, each of the machine learning models may be trained to identify a pre-defined simulation scenario from the technical document. Each of the machine learning models identify at least one word phrase from a sentence in the technical document.

In an embodiment, the method of extracting one or more phrases of words from at least one sentence further comprises generating bounding boxes around one or more phrases of words from the at least one sentence in the technical document. The method of extracting one or more phrases of words from at least one sentence further comprises identifying a first semantic relationship between one or more phrases of words and a second semantic relationship between one or more textual elements in a particular phrase. The method of extracting one or more phrases of words from at least one sentence further comprises extracting the one or more phrases or combination thereof of phrases of words from the at least one sentence based on the first semantic relationship and the second semantic relationship.

In an embodiment, the method of extracting one or more phrases of words from at least one sentence further comprises determining co-reference relationship between one or more textual elements in the at least one sentence from the technical document using one or more machine learning models. In a further embodiment, the method of determining co-reference between the textual elements using the one or more machine learning models comprises filtering out one or more noun phrases from the sentences in the technical document. The method of determining co-reference between the textual elements using the one or more machine learning models comprises determining associations between the relevant noun phrases in the sentences in the technical document using the one or more machine learning models.

In an embodiment, the method of determining co-reference between one or more textual elements extracted from the sentence in the technical document comprises training the one or more machine learning models. Herein, training the one or more machine learning models comprises extracting feature vectors pertaining to distance, string match, number agreement, and apposition for the one or more textual elements, wherein one textual element is an anaphor and other textual element is an antecedent. The method further comprises training the one or more machine learning models based on the extracted features.

In an embodiment, the method further comprises grouping the one or more textual elements with the same syntactic role into phrases of words. The method further comprises labelling the semantic role of each phrase of word using a semantic role labelling model using a plurality of syntactic and lexical features extracted from the technical document.

The method comprises assigning, by the processing unit, the at least one word phrase to a header in a preconfigured template using a classifier model, wherein the preconfigured template comprises one or more categories of headers. The preconfigured template is capable of semantically describing the simulation scenario when populated with extracted word phrases. In an embodiment, the method of assigning the at least one word phrase to a header in the preconfigured template further comprises calculating a confidence score for assigning the at least one word phrase to a header in the preconfigured template using the classifier model. The method of further comprises assigning the at least one word phrase to a header in the preconfigured template if the confidence score is above a predefined threshold value.

The method comprises generating, by the processing unit, one or more simulation scenarios using the preconfigured template having headers assigned to the least one word phrase. In an embodiment, the method of generating the one or more simulation scenarios comprises extracting an intent of semantics of the text-based specifications based on the preconfigured template having headers correlated with the at least one word phrase for the particular simulation scenario. In an embodiment, the one or more categories of the headers in the preconfigured template comprises at least of: condition, input, system, environment, action, overall result, and overall qualifier.

The object of the present invention is achieved by an apparatus for generating one or more simulation scenarios for a simulation model in a simulation environment pertaining to one or more assets in an environment. The apparatus comprises one or more processing units and a memory unit communicatively coupled to the one or more processing units. The memory unit comprises a module stored in the form of machine-readable instructions and executable by the one or more processing units, wherein the module is configured to perform method steps according to any of the methods as described above. The execution of the module may also be performed using co-processors such as Graphical Processing Unit (GPU), Field Programmable Gate Array (FPGA) or Neural Processing/Compute Engines. In addition, the memory unit may also include a database.

In another embodiment, the apparatus is a cloud computing system having a cloud computing based platform configured to provide a cloud service for generating one or more simulation scenarios for a simulation model in a simulation environment pertaining to one or more assets in a facility. As used herein, "cloud computing" refers to a processing environment comprising configurable computing physical and logical resources, for example, networks, servers, storage, applications, services, etc., and data distributed over the network, for example, the internet. The cloud computing platform may be implemented as a service for providing access to multimodal content in a technical document. In other words, the cloud computing system provides on-demand network access to a shared pool of the configurable computing physical and logical resources. The network is, for example, a wired network, a wireless network, a communication network, or a network formed from any combination of these networks.

The object of the present invention is also achieved by a system comprising one or more client devices and an apparatus as described above, communicatively coupled to the one or more client devices, for generating one or more simulation scenarios for a simulation model in a simulation environment pertaining to one or more assets in a facility.

The object of the present invention is also achieved by a computer-readable medium, on which program code sections of a computer program are saved, the program code sections being loadable into and/or executable by a processor which performs the method as described above when the program code sections are executed.

The above-mentioned attributes, features, and advantages of this invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:
- FIG 1A: illustrates a block diagram of a system for generating one or more simulation scenarios for a simulation model in a simulation environment pertaining to one or more assets in an environment, in accordance with an embodiment of the present invention;
- FIG 1B: illustrates a block diagram of an apparatus for generating one or more simulation scenarios for a simulation model in a simulation environment pertaining to one or more assets in an environment, in accordance with an embodiment of the present invention;
- FIG 2: depicts a flowchart of a method for generating one or more simulation scenarios for a simulation model in a simulation environment pertaining to one or more assets in an environment, in accordance with an embodiment of the present invention; and
- FIG 3: shows an exemplary workflow of the method for generating one or more simulation scenarios for a simulation model in a simulation environment pertaining to one or more assets in an environment, in accordance with an embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

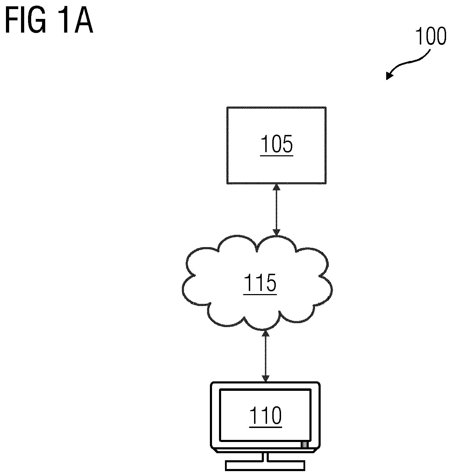

FIG 1A illustrates a block diagram of a system 100 for generating one or more simulation scenarios for a simulation model in a simulation environment pertaining to one or more assets in an environment, in accordance with an embodiment of the present invention.

The term "assets" as used herein refers to any autonomous systems that are capable of automatically performing one or more tasks subject to training of the assets. In an example, the assets may include autonomous systems such as automatic machines, robots, autonomous vehicles, automatic electro-mechanical systems etc.

Operators and other users can interact with the assets, for example, to facilitate performing manual operations to facilitate operation of an assets and/or monitoring or managing machines or processes associated with the assets. For example, operators and other users can interact with (e.g., work with, monitor, manage, etc.) industrial devices, industrial processes, control programs, human machine interfaces (HMIs), etc., associated with the assets, to facilitate operation of the assets. Example of assets include nay machinery, system or apparatus trained for performing an automated operation such as industrial robots, crane systems, conveyor systems, autonomous vehicles etc. In an example, the assets are trained to perform desired operations using training dataset. In a specific embodiment, the assets are trained in a simulation environment for which a large number of simulation scenarios are generated.

The simulation environment may be based on one or more of physics-based models, Computer-Aided Design (CAD) models, Computer-Aided Engineering (CAE) models, one-dimensional (1D) models, two-dimensional (2D) models, three-dimensional (3D) models, finite-element (FE) models, descriptive models, metamodels, stochastic models, parametric models, reduced-order models, statistical models, heuristic models, prediction models, ageing models, machine learning models, Artificial Intelligence models, deep learning models, system models, surrogate models and the like.

In the present embodiment, the simulation environment hosts a simulation model that is built based on test operation data such as simulation data, experimental data and mathematical data associated with a plurality of operations/functionalities to be performed by the asset. The simulation data is generated by simulating a behavior of the industrial automation system in an environment corresponding to inputs provided to the asset, modifications to the environment of the asset, one or more requirements or expected outcome of the asset, one or more requests from the operators/users for assets and so forth. The simulation environment may be provided by a computer-aided simulation tool on the system 102. Based on the simulation model, simulation instances are generated. The simulation instances are executed in the simulation environment to generate the simulation data for operation of a particular asset. Furthermore, the simulations instances are executed in the simulation environment to generate simulation data for operation of the assets as per the inputs and possible change in the environment. In a specific embodiment, the simulation scenarios are generated based on a plurality of technical documents from a source. The technical documents comprise text-based specifications pertaining to behavior of the assets in the simulation environment. The simulation scenarios are generated by extracting an intent of semantics of the text-based specifications based on a preconfigured template having headers correlated with the at least one word phrase for a particular simulation scenario. By 'intent' is meant a goal of simulation scenario which may relate to an underlying purpose operation of the asset.

The system comprises an apparatus 105 and one or more client devices 110. Non-limiting examples of client devices 110 include personal computers, mobile phones, personal digital assistants and workstations. In the present embodiment, the apparatus 105 is a server. The one or more client devices 110 is connected to the apparatus 105 via a network 115. Non-limiting examples of the network 115 include local area network (LAN), wide area network (WAN), WiFi, etc.

The client device 110 includes a device configured to receive one or more technical documents from a user. In an example, the technical documents may be stored on the client device 110 in soft copy formats. In another example, the user may upload the technical document to the client device 110 through peripheral devices such as scanners, hard disks, CD-ROMs and so on. In case of documents existing in hard copy format, the technical document may be a scanned image of the document. In addition to the technical document, the user may also provide inputs such as annotations that are specific to the technical document. The one or more client devices 110 may also be configured to convert the technical document to a format suitable for processing at the apparatus 105. The one or more client devices 110 may also include a user device, used by the user. In an embodiment, the user device may be used by the user, to send requests to the server for generating one or more simulation scenarios for a simulation model in a simulation environment pertaining to one or more assets. In another embodiment, a request may be sent to the apparatus 105 to access the results of the simulation environment via the network 115.

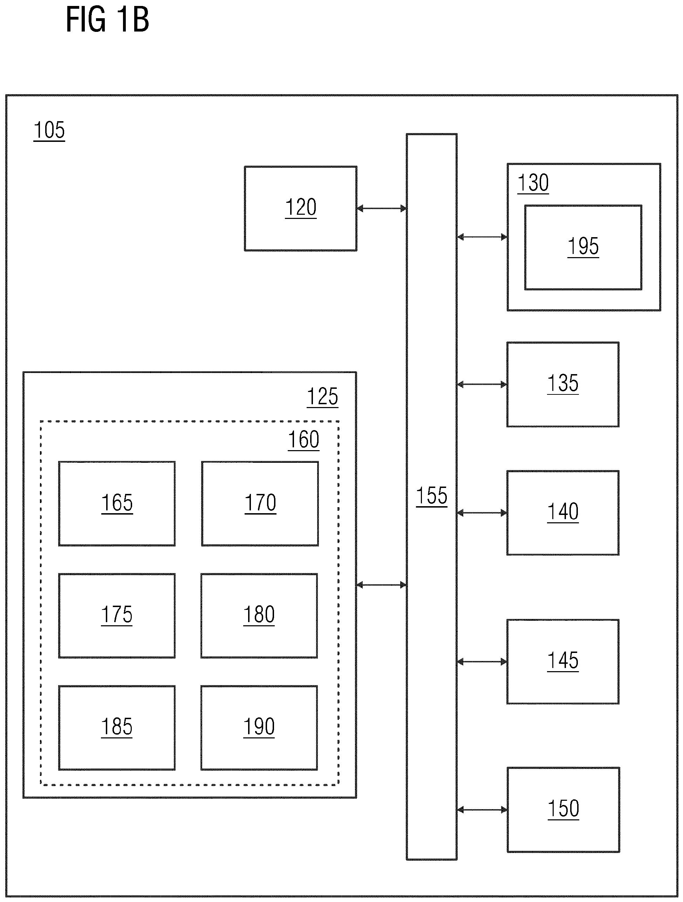

The apparatus 105 comprises a processing unit 120, a memory 125, a storage unit 130, a communication unit 135, a network interface 140, an input unit 145, an output unit 150, a standard interface or bus 155, as shown in FIG 1B. The apparatus 105 can be a (personal) computer, a workstation, a virtual machine running on host hardware, a microcontroller, or an integrated circuit. As an alternative, the apparatus 105 can be a real or a virtual group of computers (the technical term for a real group of computers is "cluster", the technical term for a virtual group of computers is "cloud"). The term 'processing unit', as used herein, means any type of computational circuit, such as, but not limited to, a microprocessor, a microcontroller, a complex instruction set computing microprocessor, a reduced instruction set computing microprocessor, a very long instruction word microprocessor, an explicitly parallel instruction computing microprocessor, a graphics processor, a digital signal processor, or any other type of processing circuit.

The processing unit 120 may also include embedded controllers, such as generic or programmable logic devices or arrays, application specific integrated circuits, single-chip computers, and the like. In general, the processing unit 120 may comprise hardware elements and software elements. The processing unit 120 can be configured for multithreading, i.e. the processing unit 120 may host different calculation processes at the same time, executing the either in parallel or switching between active and passive calculation processes.

The memory 125 may include one or more of a volatile memory and a non-volatile memory. The memory 125 may be coupled for communication with the processing unit 120. The processing unit 120 may execute instructions and/or code stored in the memory 125. A variety of computer-readable storage media may be stored in and accessed from the memory 125. The memory 125 may include any suitable elements for storing data and machine-readable instructions, such as read only memory, random access memory, erasable programmable read only memory, electrically erasable programmable read only memory, hard drive, removable media drive for handling compact disks, digital video disks, diskettes, magnetic tape cartridges, memory cards, and the like. The memory 125 comprises a knowledge management module 160 that may be stored in the memory 125 in the form of machine-readable instructions and executable by the processing unit 120. These machine-readable instructions when executed by the processing unit 120 causes the processing unit 120 to perform functions associated with generating one or more simulation scenarios for a simulation model in a simulation environment pertaining to assets.

The module 160 comprises a preprocessing module 165, an extraction module 170, coreference relationship determination module 175, semantic role labelling module 180, classification module 185, and a simulation scenario generation module 190.

The preprocessing module 165 is configured to receive and process a request for generating simulation scenarios from a technical document received from a source such a database or one or more client devices 110. The technical document comprises text-based specifications pertaining to behavior of the one or more assets in the simulation environment. The extraction module 170 is configured to extract at least one word phrase from at least one sentence pertaining to a particular simulation scenario in the technical document.

The extraction module 170 is configured for automatically parsing the technical document using one or more machine learning models. The extraction module 170 is configured for generating bounding boxes around one or more phrases of words from the at least one sentence in the technical document and identifying a first semantic relationship between one or more phrases of words and a second semantic relationship between one or more textual elements in a particular phrase. The extraction module 170 is configured for extracting the one or more phrases or combination thereof of phrases of words from the at least one sentence based on the first semantic relationship and the second semantic relationship.

The coreference relationship determination module 175 is configured for determining co-reference relationship between one or more textual elements in the at least one sentence from the technical document using one or more machine learning models. Herein, in determining co-reference between the textual elements using the one or more machine learning models, the coreference relationship determination module 175 is configured for filtering out one or more noun phrases from the sentences in the technical document and determining associations between the relevant noun phrases in the sentences in the technical document using the one or more machine learning models. Further, the coreference relationship determination module 175 is configured for extracting feature vectors pertaining to distance, string match, number agreement, and apposition for the one or more textual elements, wherein one textual element is an anaphor and other textual element is an antecedent and training the one or more machine learning models based on the extracted features.

The semantic role labelling module 180 comprises grouping the one or more textual elements with the same syntactic role into phrases of words. Further, the semantic role labelling module 180 comprises labelling the semantic role of each phrase of word using the classifier model using a plurality of syntactic and lexical features extracted from the technical document.

The classification module 185 is configured for assigning, the at least one word phrase to a header in a preconfigured template using a classifier model. Herein, the preconfigured template comprises one or more categories of headers, and wherein the preconfigured template is capable of semantically describing the simulation scenario when populated with extracted word phrases. Further, the classification module 185 is configured for calculating a confidence score of the classifier model for assigning the at least one word phrase to a header in the preconfigured template and assigning the at least one word phrase to a header in the preconfigured template if the confidence score is above a predefined threshold value.

The simulation scenario generation module 190 is configured for generating one or more simulation scenarios using the preconfigured template having headers assigned to the least one word phrase.

The storage unit 130 comprises a non-volatile memory which stores the database 195. The database 195 may store, for example, representations of multimodal content extracted from various technical documents, corpus and so on. The input unit 145 may include input means such as keypad, touch-sensitive display, camera, etc. capable of receiving inputs. The output unit 150 may include output means such as monitors, Human Machine Interfaces etc. The bus 155 acts as interconnect between the processing unit 120, the memory 125, the storage unit 130, and the network interface 140. The communication unit 135 enables the apparatus 105 to communicate with the one or more client devices 110. The communication unit 135 may support different standard communication protocols such as Transport Control Protocol/Internet Protocol (TCP/IP), Profinet, Profibus, Bluetooth and Internet Protocol Version (IPv). The network interface 140 enables the apparatus 105 to communicate with the one or more client devices 110 over the network 115.

The apparatus 105 in accordance with an embodiment of the present invention includes an operating system employing a graphical user interface. The operating system permits multiple display windows to be presented in the graphical user interface simultaneously with each display window providing an interface to a different application or to a different instance of the same application. A cursor in the graphical user interface may be manipulated by a user through the pointing device. The position of the cursor may be changed and/or an event such as clicking a mouse button, generated to actuate a desired response.

One of various commercial operating systems, such as a version of Microsoft Windows^{™}, may be employed if suitably modified. The operating system is modified or created in accordance with the present invention as described.

Those of ordinary skilled in the art will appreciate that the hardware depicted in FIGS 1A and 1B may vary for different implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter, network connectivity devices also may be used in addition or in place of the hardware depicted. The depicted example is provided for the purpose of explanation only and is not meant to imply architectural limitations with respect to the present invention.

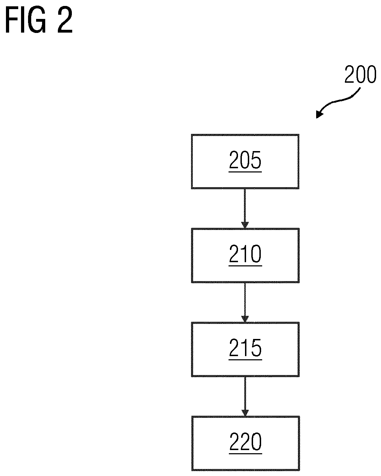

FIG 2 depicts a flowchart of a method 200 for generating one or more simulation scenarios for a simulation model in a simulation environment pertaining to one or more assets, in accordance with an embodiment of the present invention.

At step 205, a technical document is recevied from a source by the processing unit 120. The technical document comprises text-based specifications pertaining to behavior of the one or more assets in the simulation environment. The technical document comprises natural language content in the form of text, tables, mathematical expressions, etc. The source may be one or more of a client device, a database or a server. Further, the natural language may be one of structured data and unstructured data. The technical document is in one of a searchable format and a non-searchable format. Specifically, searchable formats allow a user to search through the document for specific text with the help of keywords. Non-limiting examples of searchable formats include knowledge models, searchable PDFs, emails, Word, Excel and HTML. On the contrary, non-searchable formats non-searchable Portable Document Formats (PDFs), Portable Network Graphics (PNG) format, Joint Photographic Experts Group (JPEG) format, JPEG, JPG and other image formats. In one example, the technical document may be a scanned image of a hard copy. Non-limiting examples of technical documents include service reports, product catalogs, product manuals, user guides, and so forth. In an embodiment, receiving the request comprises receiving the technical document from the client device 110. The technical document may be in any document format, including but not limited to, PDF, JPEG, JPG, PNG, TIFF. In one example, the technical document is a scanned image of a document in hard copy form. It should be understood that the technical document comprises information about operation and behavior of the assets. Advantageously, the technical document received is processed to semantically understand the intent of the text-based specifications in order to generate one or more simulation scenarios for the assets.

At step 210, at least one word phrase is extracted from at least one sentence pertaining to a particular simulation scenario in the technical document. The sentences in the technical document may indicate the operation and behavior of the assets in spoken language form. The word phrases are one or more chunks of words that are extracted from a sentence to understand the meaning of the sentence in an accurate manner. It should be appreciated that the technical document comprises a plurality of sentences that are written in natural language that pertain to operation and behavior of the assets in a multitude of scenarios. The technical document may comprise specifications of the assets under various operating conditions. Advantageously, the system is trained to extract relevant sentences and word phrases for a particular asset from the technical document and generate simulation scenarios from therein. For this purpose, the sentences in the technical document are broken down into small phrases of words and then and semantically related to extract intent from the sentences.

In an embodiment, extracting at least one word phrase from at least one sentence comprises automatically parsing the technical document using one or more machine learning models. Each of the one or more machine learning models is trained to perform a certain function. In particular, by training based on training data, the machine learning model is able to adapt to new circumstances and to detect and extrapolate patterns. In general, parameters of the machine learning model may be adapted by means of training. In particular, supervised training, semi-supervised training, unsupervised training, reinforcement learning and/or active learning may be used. Furthermore, feature learning may be used. In particular, the parameters of the machine learning model may be adapted iteratively by several steps of training. In particular, a machine learning model may comprise a neural network, a support vector machine, a decision tree and/or a Bayesian network, and/or the machine learning model may be based on k-means clustering, Qlearning, genetic algorithms and/or association rules. Specifically, each of the machine learning models may be trained to identify at least one word phrase from a sentence in the technical document and then generate semantic relationships therein. The one or more machine learning models are trained to perform dependency parsing on the sentences for analyzing the grammatical structure of the sentences based on dependencies imbibed. The one or more machine learning models are trained to provide a representation of the structure of the sentence and relationships between one or more phrases of the sentence. Further, the one or more machine learning models are trained to perform constituency parsing on the sentences. Constituency parsing is the task of breaking a text into sub-phrases, or constituents. Non-terminals in the parse tree are types of phrases, the terminals are the words in the sentence.

In an embodiment, the method of extracting one or more phrases of words from at least one sentence further comprises generating bounding boxes around one or more phrases of words from the at least one sentence in the technical document. The bounding boxes define the boundary of phrases of words in the sentence that are to be analyzed further. Once the boundary of phrases of words is defined, a first semantic relationship is identified between one or more phrases of words. Herein, the first semantic relationship is the interrelationship between one or more phrases of words i.e. the semantic relationship between the words in two bounding boxes. Further, a second semantic relationship is identified between one or more textual elements in a particular phrase. Herein, the second semantic relationship is the intrarelationship between the words or textual elements i.e. the semantic relationship between the textual elements in the same bounding box. Subsequently, the one or more phrases or combination thereof of phrases of words are extracted from the at least one sentence based on the first semantic relationship and the second semantic relationship. In an example, noun phrases and verb phrases are identified from the sentences and then semantic relationship is identified between each noun phrase, each verb phrase and the relationship between the noun phrase and related verb phrase.

In an embodiment, extracting one or more phrases of words from at least one sentence further comprises determining co-reference relationship between one or more textual elements in the at least one sentence from the technical document using one or more machine learning models. Co-reference relationship is the semantic relation between two words that indicate how a particular word relates to another word and what is the intended meaning drawn from the relationship. The method of determining co-reference between the textual elements using the one or more machine learning models comprises filtering out one or more noun phrases from the sentences in the technical document. The one or more machine learning models are trained to resolving repeated references to an object in the technical document. A co-reference relationship denotes identity of reference that holds between two textual elements sometimes known as 'markables'. The textual elements can be noun phrases, demonstrative noun phrases, proper names, appositives, sub-noun phrases that act as modifiers, pronouns and so on. The method further comprises determining associations between the relevant noun phrases in the sentences in the technical document using the one or more machine learning models. The one or more machine learning models are trained to determine if a pair of markables is co-referent or not. Advantageously, the co-reference resolution is required to link and make infromed choices of filtering out the relevant noun phrases and their association in the sentences from the technical document.

In an embodiment, the method of training the one or more machine learning models for determining co-reference between one or more textual elements extracted from the sentence in the technical document comprises extracting feature vectors pertaining to distance, string match, number agreement, and apposition for the one or more textual elements. Herein, the one textual element is an anaphor and other textual element is an antecedent. Further, the one or more machine learning models are trained to determine the co-reference between one or more textual elements based on the extracted features. In an example, consider the feature vector based on two extracted textual elements or markables as 'i' and 'j', wherein 'i' is the potential antecedent and 'j' is the anaphor. The one or more machine learning models are trained on how markable 'i' is related to markable 'j'. The training data is generated using the heuristic based approach with the aspect of positive and negative examples. The model can then be trained using a basic classifier such as random forest model with the aspect of pruning the model.

At step 215, the at least one word phrase is assigned to a header in a preconfigured template using a classifier model. In an embodiment, the method further comprises grouping the one or more textual elements with the same syntactic role into phrases of words. By 'syntactic role' is meant the underlying rules that define or clarify the order in which words or elements are arranged to form larger elements, such as phrases, clauses, or statements. Therefore, the textual elements that form a larger meaning in a sentence are grouped together to form a phrase of words. Further, the method comprises labelling the semantic role of each phrase of word using the classifier model using a plurality of syntactic and lexical features extracted from the technical document. The classifier model performs labelling on each phrase of words extracted from the sentences in the technical document. It should be noted that the abovementioned steps of parsing and co-reference relationship determination will generate association between noun phrases along with focusing on the relevant noun phrases. Subsequently, the classifier model is trained on classifying each of the phrases of words into a header in the preconfigured template. In one example, the classifier model is trained on a feature based classification. Herein, the classifier model is based on supervised classification and the training data set (of technical documents and plurality of OEM requirements) is annotated with classes mentioned in the preconfigured template. Further, the parser features, coreference relationship features and semantic role labelling features are used to train the classifier model for automatically populating the preconfigured template. In another example, the classifier model is trained on rule based classification. Herein, the classifier model is based on a set of linguistic rules from dependency relation features and labelled roles such as parse rules. In rule based classification, each intent or category in the preconfigured template is governed by the set of rules and the classifier models matches the parse rules and intent rules for template matching. Herein, the dependency and semantic roles features are configured to perform a rule based soft classification into one of the categories in the preconfigured template.

The preconfigured template comprises one or more categories of headers. The preconfigured template is capable of semantically describing the simulation scenario when populated with extracted word phrases. In an embodiment, the one or more categories of the headers in the preconfigured template comprises at least of: condition, input, system, environment, action, overall result, and overall qualifier. It should be appreciated that the preconfigured template is configured for a particular asset system by holistically exploring the various components, elements, procedures, available sources, available specifications, available technical documents for generation of simulation scenarios.

An example of a particular preconfigured template is shown below in Table 1:

**Table 1**

| | |
|---|---|
| **Condition** | <Under which a rule is applicable> |
| **Input** | <The overall trigger for a rule to be applicable> |
| **System** | <The artifact enabling the activity> |
| **Environment** | <The condition of the context when an activity takes place> |
| **Action** | <start_stimulus> <object> |
| | <start_object_state> <task> |
| | <end_stimulus><end_object state> |
| **Overall Result** | <Resultant of the overall rule> |
| **Overall Qualifier** | <Constraint under which the rule is applicable, or rule should adhere to. You can have multiple qualifiers> |

In an embodiment, the method of assigning the at least one word phrase to a header in the preconfigured template further comprises calculating a confidence score of the classifier model for assigning the at least one word phrase to a header in the preconfigured template. Herein, confidence score is a qualitative measure of accuracy of assignment of one or more phrases to a category or header in the preconfigured template. Further, the method comprises assigning the at least one word phrase to a header in the preconfigured template if the confidence score is above a predefined threshold value.

At step 220, generating, by the processing unit, one or more simulation scenarios using the preconfigured template having headers assigned to the least one word phrase. In an embodiment, the method of generating the one or more simulation scenarios comprises extracting an intent of semantics of the text-based specifications based on the preconfigured template having headers correlated with the at least one word phrase for the particular simulation scenario. Notably, once the preconfigured template is populated based on the intent of the semantics of the text-based specifications as extracted in the previous method steps.

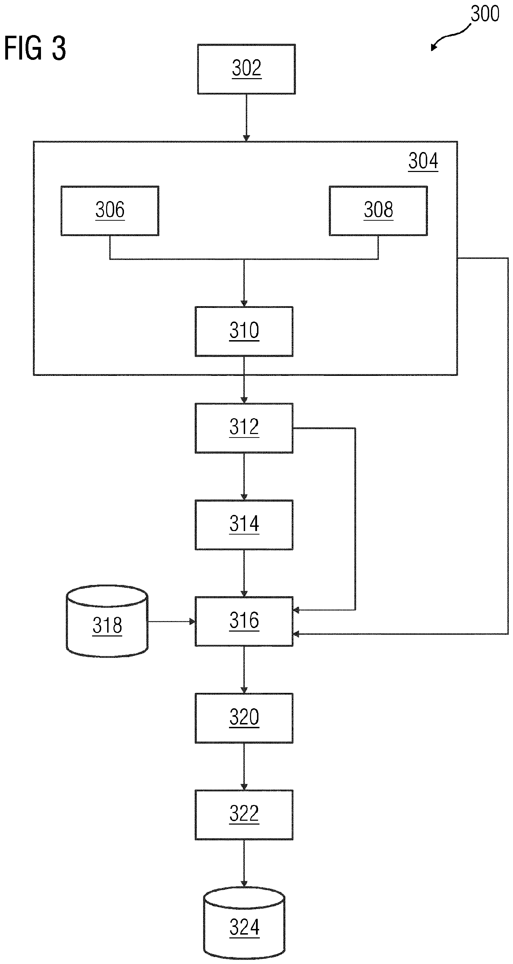

FIG 3 shows an exemplary workflow 300 of the invention including modules configured for generating one or more simulation scenarios for a simulation model in a simulation environment pertaining to an asset, in accordance with an embodiment of the present invention.

The technical documents comprising text-based specifications pertaining to behavior of the asset in the simulation environment are stored in a source such as OEM requirement database 302. The database 302 comprises a plurality of technical documents having information pertaining to the behavior of the assets. In an example, the technical document comprises rules specified by a manufacturer that describes how an autonomous vehicle should behave in a given scenario. The environment in which the AV is, conditions under which it is operating and the how it has to behave, all these are described in a natural language in the technical document.

The techncial document from the requirement database 302 is acquired by the sentence simplification module 304. The sentence simplification module 304 is configured for extracting at least one word phrase from at least one sentence pertaining to a particular simulation scenario in the technical document. In an example, the particular technical document comprises rules specified by a manufacturer that describes how an autonomous vehicle should behave in a given scenario. Herein, the sentence "*If two vehicles arrive at the same time the vehicle on the left must yield to the vehicle on the right to avoid collision"* is extracted from the technical document.

The sentence simplification module 304 comprises a dependency parser 308, a constituency parser 310 and a noun/verb phrase identifier 312. Advantageously, the sentence simplification module 304 is capable of understanding the conditionality aspects in the technical document by simplifying, splitting, and rephrasing a complex sentence into multiple smaller sentences or phrases of words without loosing any information. The dependency parser 308 is configured for analyzing the grammatical structure of a sentence based on the dependencies imbibed that gives us a representation with patterns of the relations. Further, the constituency parser 310 is configured for breaking a text into sub-phrases, or constituents. Non-terminals in the parse tree are types of phrases, the terminals are the words in the sentence.

Further, the noun/verb phrase identifier 312 is capable of identifying noun phrases and verb phrases by combining both constituency parser and dependency parser and enabling better identification from the sentence. The noun/verb phrase identifier 312 is configured for identifying the base noun phrases that have a flat representation with noun including their description/attributes. For instance, in the sentence "*If two vehicles arrive at the same time the vehicle on the left must yield to the vehicle on the right to avoid collision"* it is identified *"two vehicles"* comes in a base noun chunk whereas "IF" becomes a mark reflecting to the conditionality.

Further, the noun/verb phrase identifier 312 is capable of identifying Verb chunk referring to the portion of a sentence that contains both the verb and either a direct or indirect object can be extracted using the parsing results with verb phrases. These verb phrase or verb chunks are associated with the noun chunks and includes propositions associations. For instance, in the sentence "*If two vehicles arrive at the same time the vehicle on the left must yield to the vehicle on the right to avoid collision"* it is identified that *"arrive at the same time"* comes in as verb phrase with association of noun phrase *"two vehicles".*

Advantageously, by combining the dependency parser 308 and the constituency parser 310, we have noun phrases and verb phrases from the constituency parser and dependency parser gives syntactic relations between phrases of words and informs the argument typology of the phrases of the words. Advantageously, from sentence simplification module 304, the boundaries of the one or more phrases of words are identified and the relationship between these noun phrases and verb phrases are identified. In other words, intra-relationship and inter-relationship between phrases of words are identified.

Once the sentence is simplified and is broken down into phrases of words by the sentence simplification module 304, it is further provided to a conference resolution module 312. The conference resolution module 312 is configured for determining co-reference between one or more textual elements extracted from the sentence in the technical document. The coreference resolution module 312 aims at resolving repeated references to an object in the technical document.

Specifically, a coreference relationship denotes an identity of reference that holds between two textual elements known as markables, which can be definite noun phrases, demonstrative noun phrases, proper names, appositives, sub-noun phrases that act as modifiers, pronouns, and so on. The coreference resolution module 312 is configured for training the one or more machine learning models to determine if a pair of markables is co-referent or not. Advantageously, the coreference resolution module 312 is required to link and make informed choices of filtering out the relevant noun phrases and find their associations in the text. The task of finding all expressions that refer to the same entity/entities in a text ensures that the intent of the sentence is understood accurately.

For instance, in the example sentence: "If two vehicles, arrive at the same time the vehicle_{b} on the left must yield to the vehicle_{c} on the right to avoid collision."

*"vehicles_{b}"* and *"vehicles_{c}"* refer to the "same two vehicles" in the sentence.

The one or more machine learning models are trained for coreference resolution with a feature-based approach. The features are derived based on two extracted markables (i.e noun phrases identified in the previous steps), i and j, where i is the potential antecedent and j is the anaphor. Information needed to derive the feature vectors is provided by the pipeline of language-processing modules for sentence simplification. The one or more features used to train the one or more machine learning models are elaborated below in Table 2:

**Table 2**

| | |
|---|---|
| Distance Feature (DIST) | This feature captures the distance between i and j. If i and j are in the same sentence, the value is 0; if they are one sentence apart, the value is 1; and so on |
| Pronoun Feature | If token is a pronoun, return true; else return false |
| String Match Feature (STR_MATCH) | If the string of i matches the string of j, return true; else return false. We first remove articles (a, an, the) and demonstrative pronouns (this, these, that, those) from the strings before performing the string comparison |
| Number Agreement Feature (NUMBER) | If i and j agree in number (i.e., they are both singular or both plural), the value is true; otherwise false. Pronouns such as they and them are plural, while it, him, and so on, are singular. The morphological root of a noun |
| | is used to determine whether it is singular or plural if the noun is not a pronoun. |
| Appositive Feature (APPOSITIVE) | Its possible values are true or false. If j is in apposition to i, return true; else return false. Our system determines whether j is a possible appositive construct by first checking for the existence of verbs and proper punctuation. Like the above example, most appositives do not have any verb; and an appositive is separated by a comma from the most immediate antecedent, i, to which it refers. Further, at least one of i and j must be a proper name |

The training data will be generated using the heuristic based approach with the aspect of positive and negative examples. The one or more machine learning models can be then trained using a basic classifier such as random forest with the aspect of pruning the model.

Further, the sentence with determined co-reference relationship between the one or more textual elements of the phrases of words is then provided to the semantic role labelling module 314. The semantic role labelling module 314 is configured for determining the latent predicate argument structure of a natural language text and retrieving representation that can be used for better natural language understanding tasks. The predicate argument structure on text with determined natural language parsing along with reference resolution from coreference model gives us the structure to make concrete sense/intent for noun phrases with verbs at the center of it. Advantageously, the semantic role labelling module 314 aims to concretize the requirement into a structure which can identify feature for the next step of relating the phrases of words to the preconfigured template which is intent-based.

Further, candidate phrase association module 316 takes inputs from the sentence simplification module 304 and coreference resolution module 312 to generate association between noun phrases along with focusing on the relevant verb phrases. Further, the candidate phrase association module 316 also takes inputs from the semantic role labelling module 314 that determines the argument types expected by the verb. Further, the candidate phrase association module 316 determines a confidence score of the associations between phrases of the words by utilizing linguistic patterns stored in a VerbNet database 318. These linguistic patterns such as for word *"yield"* its NP VB NP which helps us in identifying two relevant phrases related to yield i.e *"vehicle on the left"* and *"vehicle on the right".* In a case when there are multiple arguments, the confidence score for the candidates can be retrieved with the help of association retrieved from parsing and coreference resolution.

Further, the linguistic features determination module 320 identifies the phrases of words that are semantically and linguistically related to one another such that the phrases of words are meaningful. These linguistic features are then fed into a classifier module 322 that populates the preconfigured template comprising one or more categories of headers, and wherein the preconfigured template is capable of semantically describing the simulation scenario when populated with extracted word phrases from the linguistic features determination module 320. The one or more categories of the headers in the preconfigured template comprises at least of: condition, input, system, environment, action, overall result, and overall qualifier as described above in Table 1. The classifier module 322 uses a feature based classification model or a rule based classification model to populate the preconfigured template. In case of feature based classification model, a plurality of techncial documents are annotated with the predetermined classes or headers of the preconfigured template and then the classification model is trained on the plurality of annotated technical documents to accurately populate the preconfigured template. Rule based classification: we formulate a set of linguistic defined rules from the dependency relation features and labelled roles - termed as parse rules. In case of rule based classification model, each category is governed by a set of rules which are a basis for populating the preconfigured template.

Once the preconfigured template is populated with a scenario from the technical document, the preconfigured template is stored in a database 324 that serves as input to the simulation model.

For instance, for the sentence *"If two vehicles arrive at the same time the vehicle on the left must yield to the vehicle on the right to avoid collision"*, the preconfigured template is populated as shown below in Table 3:

**Table 3**

| | |
|---|---|
| System | Two Vehicles (vehicle on the left and vehicle on the right forms association with coreference resolution) |
| Condition/Input | two vehicles arrive at the same time |
| Action | Yield (vehicle on the left yield to the vehicle on the right) |
| Overall Result | Avoid Collision |

The present invention approaches the problem from a fresh perspective of extracting V&V scenarios directly from the requirements in the knowledge base rather than the current approach of relying purely on mathematical estimations. It also automates the overall process involved in scenario creation for both training and V&V of AV algorithms. Advantageously, the present invention provides a method to extract the intent of the techncial document and automatically generate simulation scenarios from a technical manual of a particular asset. Furthermore, the invention eliminates the need of manual interpretation of scenarios which is time consuming. It will be appreciated that the present invention automatically creates simulations scenarios from requirement knowledge base that decreases domain expert dependency, reduces cost, and decreases time to market for the OEMs of assets such as Avs. Furthermore, the automatic extraction of the intent from the knowledge base with high accuracy and minimized ambiguity using the holistic intent template de-risks the usage of machine learning techniques in a regulated environment like AVs. Advantageously, this invention is based on a linguistic feature-based application pipeline which contributes to the automate the extraction on intents without any loss of information with concrete elements of language structure and associations. The pipeline forms a base setup to extract and retrieve the intent for respective elements in the natural language text utilizing the linguistically driven application components. Moreover, the present invention has an open and standardized representation with domain agnostics aspects which can be replicated for other domains and languages.

The present invention may take the form of a computer program product comprising program modules accessible from computer-usable or computer-readable medium storing program code for use by or in connection with one or more computers, processors, or instruction execution system. For the purpose of this description, a computer-usable or computer-readable medium is any apparatus that may contain, store, communicate, propagate, or transport the program for use by or in connection with the instruction execution system, apparatus, or device. The medium may be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processors and program code for implementing each aspect of the technology may be centralized or distributed (or a combination thereof) as known to those skilled in the art.

While the invention has been illustrated and described in detail with the help of a preferred embodiment, the invention is not limited to the disclosed examples. Other variations may be deducted by those skilled in the art without leaving the scope of protection of the claimed invention.

List of reference numbers:
100 system for generating one or more simulation scenarios for a simulation model in a simulation environment pertaining to one or more assets in an environment
105 apparatus
110 client device(s)
115 network
120 processing unit
125 memory
130 storage unit
135 communication unit
140 network interface
145 input unit
150 output unir
155 bus
160 module
165 preprocessing module
170 extraction module
175 coreference relationship determination module
180 semantic role labelling module
185 classification module
190 simulation scenario generation module
200 method for generating one or more simulation scenarios for a simulation model in a simulation environment pertaining to one or more assets
300 exemplary workflow of the invention including modules configured for generating one or more simulation scenarios for a simulation model in a simulation environment pertaining to an asset

## Claims

1. A computer-implemented method (200) for generating one or more simulation scenarios for a simulation model in a simulation environment pertaining to one or more assets in an environment, the method comprising:
receiving, by a processing unit (120), a technical document from a source, wherein the technical document comprises text-based specifications pertaining to behavior of the one or more assets in the simulation environment;
extracting, by the processing unit (120), at least one word phrase from at least one sentence pertaining to a particular simulation scenario in the technical document;
assigning, by the processing unit (120), the at least one word phrase to a header in a preconfigured template using a classifier model, wherein the preconfigured template comprises one or more categories of headers, and wherein the preconfigured template is capable of semantically describing the simulation scenario when populated with extracted word phrases; and
generating, by the processing unit (120), one or more simulation scenarios using the preconfigured template having headers assigned to the least one word phrase.

2. The method (200) according to claim 1, wherein generating the one or more simulation scenarios comprises extracting an intent of semantics of the text-based specifications based on the preconfigured template having headers correlated with the at least one word phrase for the particular simulation scenario.

3. The method (200) according to claim 1, wherein the one or more categories of the headers in the preconfigured template comprises at least of: condition, input, system, environment, action, overall result, and overall qualifier.

4. The method (200) according to claim 1, wherein extracting at least one word phrase from at least one sentence comprises automatically parsing the technical document using one or more machine learning models.

5. The method (200) according to any of the preceding claims, wherein extracting one or more phrases of words from at least one sentence further comprises:
generating bounding boxes around one or more phrases of words from the at least one sentence in the technical document;
identifying a first semantic relationship between one or more phrases of words and a second semantic relationship between one or more textual elements in a particular phrase; and
extracting the one or more phrases or combination thereof of phrases of words from the at least one sentence based on the first semantic relationship and the second semantic relationship.

6. The method (200) according to any of the preceding claims, wherein extracting one or more phrases of words from at least one sentence further comprises:
determining co-reference relationship between one or more textual elements in the at least one sentence from the technical document using one or more machine learning models.

7. The method (200) according to claim 6, wherein determining co-reference between the textual elements using the one or more machine learning models comprises:
filtering out one or more noun phrases from the sentences in the technical document; and
determining associations between the relevant noun phrases in the sentences in the technical document using the one or more machine learning models.

8. The method (200) according to any of the claims 6 and 7, further comprises training the one or more machine learning models for determining co-reference between one or more textual elements extracted from the sentence in the technical document, wherein training the one or more machine learning models comprises:
extracting feature vectors pertaining to distance, string match, number agreement, and apposition for the one or more textual elements, wherein one textual element is an anaphor and other textual element is an antecedent; and
training the one or more machine learning models based on the extracted features.

9. The method (200) according to any of the preceding claims, wherein assigning the at least one word phrase to a header in the preconfigured template further comprises:
grouping the one or more textual elements with the same syntactic role into phrases of words; and
labelling the semantic role of each phrase of word using the classifier model using a plurality of syntactic and lexical features extracted from the technical document.

10. The method (200) according to any of the preceding claims, wherein assigning the at least one word phrase to a header in the preconfigured template further comprises:
calculating a confidence score of the classifier model for assigning the at least one word phrase to a header in the preconfigured template; and
assigning the at least one word phrase to a header in the preconfigured template if the confidence score is above a predefined threshold value.

11. An apparatus (105) for generating one or more simulation scenarios for a simulation model in a simulation environment pertaining to one or more assets in an environment, the apparatus (105) comprising:
one or more processing units (120); and
a memory unit (125) communicatively coupled to the one or more processing units (120), wherein the memory unit (125) comprises a module (160) stored in the form of machine-readable instructions executable by the one or more processing units (120), wherein the module (160) is configured to perform method steps according to any of the claims 1 to 10

12. A system (100) for generating one or more simulation scenarios for a simulation model in a simulation environment pertaining to one or more assets in an environment, the system (100) comprising:
one or more client devices (110); and
an apparatus (105) according to claim 12, communicatively coupled to the one or more client devices, (110) for generating one or more simulation scenarios based on requests received from the one or more client devices (110) according to any of the method claims 1 to 10.

13. A computer-program product having machine-readable instructions stored therein, which when executed by one or more processing units (120), cause the processing units (120) to perform a method according to any of the claims 1 to 10.

14. A computer-readable storage medium comprising instructions which, when executed by one or more processing units (120), cause the one or more processing units (120) to perform a method according to any of the claims 1 to 10.
